Europäisches Patentamt

European Patent Office

Office européen des brevets

(11) Publication number: **0 482 534 A2**

# EUROPEAN PATENT APPLICATION

(21) Application number: **91117856.4**

(22) Date of filing: **19.10.91**

(51) Int. Cl.5: **C01B 33/12**

(30) Priority: **22.10.90 US 606078**

(43) Date of publication of application:
**29.04.92 Bulletin 92/18**

(84) Designated Contracting States:
**DE FR GB IT NL**

(71) Applicant: **E.I. DU PONT DE NEMOURS AND COMPANY**
**1007 Market Street**
**Wilmington Delaware 19898(US)**

(72) Inventor: **Bors, Susan L.**
**2119 Biddle Street**
**Wilmington, Delaware 19805(US)**
Inventor: **Winchester, Steven Charles**
**273 Campfield Road**
**Newark, Delaware 19713(US)**
Inventor: **Saltzberg, Michael Aaron**
**21 Woodland Drive**
**Glen Mills, Pennsylvania 19342(US)**
Inventor: **Bergna, Horacio Enrique**
**34 Vining Lane**
**Wilmington, Delaware 19807(US)**

(74) Representative: **von Kreisler, Alek, Dipl.-Chem. et al**
**Patentanwälte Von Kreisler-Selting-Werner,**
**Deichmannhaus am Hauptbahnhof**
**W-5000 Köln 1(DE)**

(54) **Process for making chemically stabilized cristobalite.**

(57) A process for making chemically stabilized cristobalite comprising sequential steps of (1) forming an aqueous dispersion of silica, alumina and Na, Ca and/or Sr oxides, (2) drying the dispersion to form amorphous particles and (3) calcining the amorphous particles to render them crystalline.

EP 0 482 534 A2

Field of Invention

The invention is directed to a process for making chemically stabilized cristobalite compositions, that is, cristobalite-like silicates which do not undergo abrupt alpha-to-beta transformation upon heating.

Background of Invention

Crystalline silica is found in nature in three distinct structures, i.e. quartz, tridymite, and cristobalite, as identified by X-ray diffraction analysis with each crystalline structure having polymorphic forms stable in different temperature ranges. In each such crystalline form of silica, a silicon atom is bonded to four oxygen atoms in tetrahedral coordination. Each form represents a distinct arrangement of silicon-oxygen tetrahedrals into a three-dimensional crystalline network. Generally crystallization temperature determines which structure is formed. Quartz is formed by crystallizing silica at temperatures below about 867°C; tridymite is formed at a crystallization temperature about 867°C to about 1470°C; and cristobalite is formed at temperature above about 1470°C. Cristobalite exists in two polymorphic forms, i.e. low cristobalite (alpha cristobalite) and high cristobalite (beta cristobalite). High cristobalite, the stable form of crystalline silica at temperatures above about 1470°C, ordinarily converts to low cristobalite when it is cooled through the temperature range of about 200-275°C.

For low dielectric constant applications, quartz is the most commonly used filler because of its high thermal coefficient of expansion (TCE). Quartz has a desirably low dielectric constant (about 4), a high TCE of about 10-12 ppm/°C in the temperature range from 25-300°C and excellent chemical durability. However, quartz undergoes a displacive alpha -> beta phase transition at 573°C, which is accompanied by a relatively large volume change. It is well-known that this abrupt volume change can cause mechanical instabilities (cracking crazing, etc.) to develop in multilayer systems upon thermal cycling through the phase transition. Quartz is not well wetted by many glasses used in low K dielectrics. Therefore, the sintering properties of quartz often limit its loading in filled glass composites. A filler with improved glass wetting properties would allow higher loadings of low-K filler, thus reducing the dielectric constant of the composite and increasing its hermeticity.

To be useful in low K multilayer composites, a material should have a smooth thermal expansion behavior (i.e., it should not undergo any phase transitions up to at least 1000°C) and should have a TCE of about 8-12 ppm/°C in the range 25-300°C. In addition, the dielectric constant should be as low as possible, preferably less than about 5, and the dielectric loss should be less than 0.3% tan δ. In addition, the filler powders should have good wetting properties in combination with a variety of glasses, forming dense composites at filler loadings of at least 20-60 vol.%. In particular, the wetting properties of the filler should allow larger filler loadings than are possible with quartz.

It has been recognized for a number of years that glass-ceramics, in which the predominant phase is stabilized high (beta) cristobalite, can be formed by crystallizing a high silica glass containing other constituents such as $Na_2O$, CaO, and $Al_2O_3$. This approach to forming high stabilized glass-ceramics was disclosed by MacDowell (US 3,445,252), who disclosed that glass compositions containing 55-90 wt.% $SiO_2$, 5-40 wt.% $Al_2O_3$, and 1-5 wt.% of CaO, CuO, or SrO crystallized to glass-ceramics with high cristobalite as the primary crystalline phase. Li (US 4,073,655) claimed high cristobalite glass-ceramic articles with improved phase purity by restricting the glass composition to those containing equimolar ratios of CaO (up to 70 mole% of CaO can be substituted by other oxides) and $Al_2O_3$.

Kaduk disclosed the formation of stabilized high cristobalite from a high pH solution containing silica and a source of boron oxide which was reacted under hydrothermal conditions in the presence of glycerol. This type of process normally forms low cristobalite. Recently, Perrota et al. (US 4,818,729) disclosed another wet chemical process for forming stabilized high cristobalite from dried gels containing silica, alumina, and any alkali or alkaline earth metal oxide excluding $Li_2O$, BeO, and MgO. They claim that the molar ratio of $Al_2O_3$ to alkali or alkaline earth oxide must be nearly equimolar, i. e. between 0.95 and 1.1, or the high cristobalite phase is not stabilized. They specify that the molar ratio of silica to alumina can vary from 10-40 to form the stabilized material. Their process requires calcination at 800-1400C for very long times (often greater than 24 hours) to form high (stabilized) cristobalite and yields a material which is substantially contaminated by other phases, such as anorthite.

Summary of Invention

In its primary aspect, the invention is directed to a process for the preparation of chemically stabilized cristobalite comprising the sequential steps of:

(a) forming a uniform aqueous dispersion of colloidal or smaller-sized particles consisting essentially on a molar basis of 2-12% alumina or precursor thereof, 90.5-97.5% silica or precursor thereof and 0.5-8% metal oxide ($Me_xO$) or precursor thereof in which Me is selected from Na, Ca, Sr and mixtures thereof and the mole ratio of $Al_2O_3$ to MeO is 0.9-5;

(b) drying the uniform aqueous dispersion of step (a) to recover finely divided amorphous particles of the oxide admixture; and

(c) calcining the amorphous particles from step (b) at a temperature of 800-1400°C for a time sufficient to render the mixture crystalline.

Definitions

As used herein, the term "chemically stabilized cristobalite" refers to cristobalite-like compounds which do not (1) undergo alpha-to-beta phase transformations, (2) do not undergo sudden changes in thermal expansion upon heating, and (3) do not contain more than 10 mole% of phases other than cristobalite.

As used herein, the term "precursor" refers to ionic compounds which upon drying and firing are decomposed to form the oxide of the cation under consideration such as water-soluble salts, carbonates, oxalates, carboxylates and the like.

Detailed Description of the Invention

It has been discovered that a material having an X-ray diffraction pattern at room temperature which is nominally the same as that of the high (beta) cristobalite crystalline form of silica and a has a dielectric constant of less than 4.5 can be synthesized from a water-based mixture containing oxides or precursors of oxides of silicon and aluminum, and of a metal oxide (MeO) of calcium, sodium, and/or strontium. The process is comprised generally of forming the dispersion, drying to recover an amorphous powder, and calcining at 800-1400°C for a time sufficient to render the material to a crystalline stabilized cristobalite.

The stabilized high cristobalite powders made by the process of this invention are intended for use as fillers in low-K glass composites. They may also be useful in high temperature structural applications where their smooth thermal expansion and thermal stability to > 1400°C are important. Fillers for low K dielectric applications require low dielectric constants, good chemical durability, and good sintering properties in combination with a variety of glasses. Ideally the filler material will not undergo an abrupt volume change due to phase transitions in the temperature range of multilayer circuit fabrication or application, 25-900°C. We have found that certain ranges of composition in the $CaO-Al_2O_3-SiO_2$, $SrO-Al_2O_3-SiO_2$, and $Na_2O-Al_2O_3-SiO_2$ systems can be synthesized with a structure seemingly identical to that of beta-cristobalite at room temperature. The dielectric constant of the stabilized cristobalites of this invention is about 3.7-4.0.

The water-based mixture used to make the amorphous precursor may contain a colloidal source of silica or a silicate sol, and an ionic solution of aluminum, and sodium, calcium, and/or strontium. This solution can be prepared by reacting any soluble salt of aluminum and soluble salt of calcium, sodium, and/or strontium and a silica source with an ammonia hydroxide solution to form a sol or slurry. The silica source can be a colloidal silica or an esterified silica. A colloidal source of silica is preferred since no organics are required.

The solution can also be prepared by mixing the soluble metal salts (aluminum and calcium, sodium, and/or strontium) with a colloidal silica without precipitation.

The soluble metal salts can be any water soluble salt. For electronic applications non-halide soluble salts are preferred. The solutions can be prepared in the range of < 1 to 23 wt.% solids. A solids loading of 2-8% is preferred for production of finely divided powders. The pH of the final solution can be as low as 3.0 or as high as 10.5. Colloidal silica sols typically contain from 30 to 50% $SiO_2$. Particularly suitable are Ludox® colloidal silicas which are available from E. I. du Pont de Nemours and Co., Wilmington, DE. These sols have pH values of 8.4-11 and the $SiO_2$ particle size is in the range of 3-30 nanometers.

Another source of $SiO_2$ is microspheres of $SiO_2$ having coated thereon stoichiometrically appropriate amounts of MeO and $Al_2O_3$.

Technical and industrial grades of $Al_2O_3$, including the hydrates thereof are suitable for the practice of the invention, as are technical and industrial grades of MeO.

As mentioned above, the chemically stabilized cristobalite composition of the invention contain by mole % 2-12% $Al_2O_3$, 90.5-97.5% $SiO_2$ and 0.5-8% MeO in which Me is Ca, Sr, Na or mixtures thereof. In addition, the mole ratio of $Al_2O_3$ to MeO is 0.9-5.

It has been found that compositions containing alkali and alkaline earth oxides other than those mentioned, in combination with alumina and silica do not yield phase pure high cristobalite.

In carrying out the process, it is desirable to maintain the uniformity of the aqueous dispersion of $SiO_2$, $Al_2O_3$ and MeO. This can be done by the use of conventional propeller-type mixers which require only a relatively small energy input to maintain dispersion uniformity.

This dispersion can be dried by conventional spray drying, freeze drying, vacuum drying or agitated pan drying. Spray drying is the preferred method to produce finely divided spherical powders. The spray dryer used was a portable laboratory model made by Niro. The atomization of the slurry can be accomplished by a rotary disk or a fluid nozzle. The rotary disk atomizer is preferred for the production of fine powders. The particles thus formed have an average diameter of about 2 to 20 $\mu$m. The particle size is dependent on the solids loading.

The dried amorphous material can be calcined at temperatures of 800-1400°C to produce a material having an X-ray diffraction pattern at room temperature identical to that of beta-cristobalite. A calcination temperature of 950-1200°C is, however, preferred to avoid the formation of unwanted crystalline phases. The phases formed and the degree of crystallization will be dependent on the composition, crystallization time and calcination temperature.

Upon completion of calcination, it may be desirable to reduce the size of the calcined particles. This can be done by conventional size reduction techniques such as ball milling, jet milling, rod milling, Sweco milling, Y-milling and the like.

The particle size of the crystalline compositions of the invention of the metal oxides components of the formulations for making the crystalline material is not per se critical. Ordinarily, the particle size will be chosen in accordance with the method of application. Thus, if the compositions are to be applied by screen printing, they must be sufficiently small to pass through the printing screen and if they are applied as a green tape, they should be no larger than the thickness of the green tape. Crystalline and metal oxide particles on the order of 1-15 microns are preferred.

It has been found that the ratio of $Al_2O_3$ to $Me_xO$ substantially affects the amount of time needed to effect crystallization by calcination. In particular, much shorter calcination times are required if the $Al_2O_3/Me_xO$ ratio is 1.5-2.5 and preferably 2.

The crystallized product of the process of the invention in all instances consists essentially of beta cristobalite, which may be an admixture with no more than 10% of other crystalline phases such as anorthite and tridymite. However, when the preferred ratios of $Al_2O_3$ to $Me_xO$ are used, the amount of other crystalline phases becomes insignificant. Thus, the process of the invention is capable of producing quite pure powders of chemically stabilized cristobalite.

EXAMPLES

Example 1

To produce 100g of stabilized cristobalite of the composition $1CaO \cdot 1Al_2O_3 \cdot 40SiO_2$ appropriate amounts of calcium nitrate hydrate and aluminum nitrate hydrate were dissolved in deionized water to produce a solution with a pH of 2.5. The pH of an appropriate amount of Du Pont Ludox® AS-40 was adjusted to 2 with nitric acid. The two dispersions were then mixed together. This solution was reacted in a continuous stir tank with an ammonium hydroxide solution to produce a sol, with a pH of 9 and a final volume of 2 liters.

The sol was spray dried at a feed rate of 30 ml/min, with an air inlet temperature of 320°C and a outlet temperature of 180°C. A curved sharp edged rotating disk was used to atomize the sol. This produced spherical powders with a surface area of ~80 $m^2$/g, and an average particle size of 6.9 $\mu$m.

The powder was placed in an alumina crucible and calcined at 1010°C for 24 hours to yield a powder with an X-ray diffraction pattern of beta-cristobalite. The surface area of the powder was reduced to < 1 $m^2$/g and the average particle size increased to 7.8 $\mu$m.

Example 2

A powder of the same composition as that of Example I which yields an x-ray diffraction pattern of beta-cristobalite can be prepared without a hydrolysis reaction. A solution containing $Ca^{2+}$ and $Al^{3+}$ was prepared as above. The appropriate amount of Du Pont Ludox® AS-40 was mixed into the calcium-aluminum solution to yield a 2 liter solution with a pH of 3. The resulting mixture was spray dried as above to produce a powder with a surface area of 70 $m^2$/g and an average particle size of 7.8 $\mu$m.

The powder was placed in an alumina crucible and fired at 1010°C for 24 hours to produce a powder with an X-ray diffraction of beta-cristobalite.

Example 3

A solution was prepared containing appropriate amounts of calcium nitrate hydrate and aluminum nitrate hydrate to yield 100 g of the composition $1CaO \bullet 1Al_2O_3 \bullet 40SiO_2$ in methanol. The appropriate amount of tetraethylorthosilicate was mixed with 123.6 g of deionized $H_2O$ and methanol to a total volume of 1700 ml. This solution was allowed to age for 15 minutes. The two solutions were then mixed to form 2 liters of a clear mixture with a pH of < 1. This mixture was then reacted in a continuous stir tank with an aqueous mixture of ammonium hydroxide to yield a slurry with a pH of 10. The slurry was then spray dried as in Example 1. The amorphous powder was calcined at 1300°C for 8 hours to produce a powder whose X-ray diffraction pattern is that of beta-cristobalite.

Example 4

A slurry was prepared as in Example 1. Instead of spray drying, the solution was freeze dried. This produced a powder with an average particle size of 9.2 $\mu$m. When fired to 1010°C for 24 hours, this powder consisted of a mixture of amorphous material and high and low cristobalite. A firing temperature of 1100°C for 24 hours was required to produce a powder whose X-ray diffraction at room temperature was that of beta-cristobalite.

Example 5

To prepare 100g of stabilized cristobalite of the composition $1Na_2O \bullet 1Al_2O_3 \bullet 20SiO_2$. the appropriate amounts of aluminum nitrate hydrate and sodium nitrate hydrate were dissolved in deionized water to produce 300 ml solution, pH = 2. The pH of the appropriate amount of Ludox® AS-40 was adjusted to 2 with $HNO_3$. The two solutions were combined and diluted with deionized water to a volume of 1 liter. This was reacted in a continuous stir tank with an aqueous ammonium hydroxide solution to yield a slurry whose final pH was 9. This slurry was spray dried at a feed rate of 30 ml/min, a hot air temperature of 310°C, using a curved sharp edge atomizing wheel. The atomizing wheel was rotating at a speed of 15,000 rpm.

The resulting amorphous powder was calcined at 1100°C for 24 hrs to produce a material whose X-ray diffraction at room temperature was that of stabilized beta cristobalite.

Examples 6-9

Solutions were prepared as in Example 1 with the starting concentrations of the solutions varied to produce final slurries with a solids loading of 5, 2.5, 1.25, and 0.625 wt.%. These slurries were spray dried as in Example 1. Crystallization to stabilized cristobalite was achieved at 1010°C for 24 hours. The solids loading of the slurry was found to affect the particle size of the amorphous and crystallized material as shown in Table I.

Table I

| Solids Loadings (wt. %) | Average Particle Size of Amorphous Powder ($\mu$m) | Average Particle Size of Crystallized Powder ($\mu$m) |
|---|---|---|
| 5 | 6.9 | 7.8 |
| 2.5 | 6.2 | 6.1 |
| 1.25 | 5.4 | 4.7 |
| 0.625 | 5.0 | 4.5 |

Example 10 and 11

The required crystallization time and temperature to produce a material whose room temperature X-ray diffraction is that of beta-cristobalite is dependent on the composition. Two compositions were prepared according to the method outlined in Example I and calcined at various temperatures for various times. The phases produced were identified by X-ray diffraction as summarized in Table II.

5

## Table II

| Composition | Temp. (°C) | Time (hrs) | Phases Formed |
|---|---|---|---|
| $1CaO:1Al_2O_3:40SiO_2$ | 800 | 36 | amorphous |
| | 1010 | 2 | amorphous |
| | 1010 | 6 | amorphous |
| | 1010 | 15 | amorphous |
| | 1010 | 24 | beta |
| $1CaO:2Al_2O_3:40SiO_2$ | 1050 | 2 | beta, amorphous |
| | 1050 | 4 | beta, amorphous |
| | 1050 | 7 | beta |
| | 1100 | 1 | beta, amorphous |
| | 1100 | 2 | beta |
| | 1100 | 4 | beta |

Example 12

Beta-cristobalite powder was made by calcining a spray dried alumina/calcia-coated colloidal silica of 100 nm particle diameter.

The coated silica was Wesol PX 90 supplied by the Wesbond Corporation, Wilmington, Delaware. Wesol PX 90 is a 22.17 wt. % solids aquasol, pH 4.05, made from 100 nm silica coated with $Al_2O_3$ and CaO. The relative composition of the solids was 40 moles $SiO_2$, 2 moles $Al_2O_3$, and 1 mole CaO.

Ninety one grams of Wesol PX 90 were diluted with 309 g of deionized water to give 5 wt. % aquasol of pH 4.12. This sol was spray dried in a Buchi/Brinkmann Mini Spray Dryer model 190. Temperature of the inlet was 215-220°C, temperature of the outlet 115-120°C.

The resultant spray dried powder was made up of porous microspheres 2 to 7 $\mu$m diameter, but most of the product as shown by the scanning electron microscope (SEM) was in the range of 2-4 $\mu$m. The product was heated at 1000°C for 24 hrs in a static furnace. X-ray diffraction analysis of the resultant material gave a pattern identical to standard pure beta-cristobalite.

Examples 13-16

(Comparison of Dielectric Properties of Filled Glass Composites Containing Quartz and Stabilized Cristobalite)

Dielectric compositions were formulated by admixing finely divided amorphous crystallizable glass particles and/or amorphous borosilicate glass particles and a silica filler (either quartz or stabilized cristobalite). The glass particles were made by mixing appropriate amounts of the glass components, heating the mixture to form a homogeneous melt, dry quenching the resultant glass through cooled rollers, and then dry milling the glass flakes into fine particles.

Casting solutions were formulated by dispersing the dielectric composition in a binder/plasticizer matrix in a volatile non-aqueous solvent in a ball mill. An acrylic binder plasticizer matrix of the type disclosed by Usala in U.S. Patent 4,613,648 was used. Specifically, the binder comprised 30% by weight terpolymer of 62.3% by weight ethyl methacrylate, 37.1% by weight methyl methacrylate; 50% by weight 1,1,1 trichloroethane; and 20% by weight methyl ethyl ketone. Dioctyl pthalate was the plasticizer and the binder/plasticizer matrix comprised binder to plasticizer in a weight ratio of about 4.5 to 5. The solvent contained the following components in the following amounts by weight:

| 1,1,1-Trichlorethane | 70-85% |
|---|---|
| Methylene Chloride | 2-7% |
| Methyl Ethyl Ketone | 4-11% |
| Isopropanol | 2-6% |
| 1,1,2-Trichloro-1,2,2-trifluoroethane | 4-10% |

The dispersions were achieved by mixing for 6-10 hours. The solutions were formed into tapes by casting onto a silicone-coated polyester film at 60°C. The thickness of the cast tapes varied between about 4.1 and 10 mils. Samples were fabricated into a substrate geometry by laminating 8 sheets together by means of a confined pressing die operated at 70°C for 20 minutes under 3000 psi. One inch by one inch laminated parts were preheated at a rate of 5°C/minute in air and held at 450°C for one hour to remove the organic binders. After binder burn-out, the parts were fired at 900°C for 60 minutes.

Dielectric parts were fabricated from mixtures of a borosilicate glass (CGW 7070, Corning Glass Works, Corning, New York), cordierite glass, and either quartz or stabilized cristobalite. The composition disclosed here as Example 13 was designed to have a thermal expansion coefficient matched to that of silicon, while that of Example 15 was designed to have a thermal expansion coefficient matched to that of alumina. The formulations (based on the weight percent solids) and dielectric properties of fired tapes of these compositions are described below.

Table III

| Example | 13 | 14 | 15 | 16 |
|---|---|---|---|---|
| Weight% CGW 7070 | 50% | 50% | 30% | 30% |
| Weight% Cordierite Glass | 25 | 25 | 57 | 57 |
| Weight% Quartz | 25 | | 13 | |
| Weight% Stabilized Cristobalite (Example #77) | | 25 | | 13 |
| Dielectric Constant | 4.5 | 4.8 | 4.5 | 4.4 |
| Dielectric Loss | 0.3% | 0.5% | 0.3% | 0.7% |

The dielectric properties of the tapes made with quartz are very similar to those of the tapes made with stabilized cristobalite. From the known dielectric properties and densities of the other components of the tapes, the dielectric constant of the stabilized cristobalite is estimated to be about 4.

Examples 17 and 18

(Comparison of Thermal Expansion Properties of Stoichiometric and Non-Stoichiometric Stabilized Cristobalite)

Two further tapes were formulated using the process described in Examples 13-16 to illustrate the superior thermal expansion properties and phase purity of the non-stoichiometric stabilized cristobalite, as compared to the previously disclosed stoichiometric material. The mechanical integrity and materials compatibility of multilayer electronic packaging systems are often controlled by the thermal expansion matching between the various layers. It is thus extremely important that the dielectric layers have smooth thermal expansion behavior, or cracking and delamination between these layers and other layers, such as alumina substrates or silicon chips, may result during circuit fabrication. We have found that, surprisingly, the expansion properties of non-stoichiometric stabilized cristobalite (containing excess alumina) are considerably more linear than those of the previously disclosed stoichiometric compositions. This can be illustrated by analyzing the thermal expansion of glass composite tapes made with the two materials, as shown below.

Table IV

| Example | 17 | 18 |
|---|---|---|
| Weight % CGW 7070 | 50% | 50% |
| Weight % Cordierite Glass | 25 | 25 |
| Weight% Stoichiometric Cristobalite (Example #10) | 25 | |
| Weight% Non-Stoichiometric Cristobalite (Example #11) | | 25 |
| TCE (ppm/°C), 25-200°C | 10.7 | 4.7 |
| TCE (ppm/°C), 200-600°C | 4.8 | 4.7 |
| Average TCE (ppm/°C), 25-600°C | 6.6 | 4.7 |

The tape made with non-stoichiometric stabilized cristobalite has a thermal expansion coefficient which does not vary appreciably over the range studied, 25-600°C. From the known TCEs and densities of the other components of the tape, the TCE of non-stoichiometric stabilized cristobalite is tape, the TCE of non-stoichiometric stabilized cristobalite is estimated to be about 10-12 ppm/°C. The tape made with stoichiometric stabilized cristobalite, on the other hand, has a much higher TCE at lower temperatures than it does at higher temperatures. The higher TCEs at low temperature are due to the presence of trace amounts of low cristobalite in these samples. Low cristobalite has a relatively high TCE, and undergoes a phase transition to high cristobalite at a temperature which can vary between about 150-270°C, depending on the exact composition and thermal history of the low cristobalite. This phase transition is accompanied by a large volume expansion. Once all of the low cristobalite has transformed into high cristobalite (at temperatures greater than about 200°C), the TCEs of the non-stoichiometric and stoichiometric samples are essentially the same. The addition of excess alumina to the compositions thus yields samples with better phase purity than the previously disclosed stoichiometric compositions, and leads to composite parts with more linear thermal expansion behavior over the full temperature range of interest.

**Claims**

1. A process for the preparation of chemically stabilized cristobalite comprising the sequential steps of:
   (a) forming a uniform aqueous dispersion of colloidal or smaller-sized particles consisting essentially on a molar basis of 2-12% alumina or precursor thereof, 90-97.5% silica or precursor thereof and 0.5-8% metal oxide ($Me_xO$) or precursor thereof in which Me is selected from Na, Ca, Sr and mixtures thereof and the mole ratio of $Al_2O_3$ to $Me_xO$ is 0.9-5;
   (b) drying the uniform aqueous dispersion of step (a) to recover finely divided amorphous particles of the oxide admixture; and
   (c) calcining the amorphous particles from step (b) at a temperature of 800-1400°C for a time sufficient to render the mixture crystalline.

2. The process of claim 1 in step (a) of which the uniform aqueous dispersion is formed as an admixture of an aqueous ionic solution of salts of the aluminum and Me with a silica sol.

3. The process of claim 1 in which the admixture is comprised of solid microspheres of $SiO_2$ having $Al_2O_3$ and $Me_xO$ coated thereon.

4. The process of claim 2 in which the uniform aqueous dispersion of step (a) is treated with ammonium hydroxide to precipitate the oxides of aluminum and Me before drying.

5. The process of claim 1 in which the uniform aqueous dispersion of step (a) is spray dried.

6. The process of claim 1 in which the uniform aqueous dispersion of step (a) is halide-free.

7. The process of claim 1 in which the calcined particles are at least 95% by weight crystalline.

8. The process of claim 1 in which the pH of the uniform aqueous dispersion of step (a) is 3-10.

9. The process of claim 1 in which the calcined particles from step (c) are milled to effect size reduction of the particles.

**10.** The process of claim 3 in which the aqueous dispersion is agitated to maintain uniformity of the dispersion.

**11.** The process of claim 1 in which Me is either Na or a mixture of Na and Ca.

**12.** The process of claim 1 in which the calcination is carried out at 950-1200°C.

**13.** The process of claim 1 in which the uniform aqueous dispersion contains 92-96% silica.